# EUROPÄISCHE PATENTSCHRIFT

(11) **EP 0 562 438 B1**
(45) Veröffentlichungstag und Bekanntmachung des Hinweises auf die Patenterteilung: **05.06.1996**
(21) Anmeldenummer: 93104355.8
(22) Anmeldetag: 17.03.1993
(51) Int. Cl.: H01H 37/76

(54) **Thermischer Schutz in SMD-Bauform**
SDM type thermal protector
Protecteur thermique du type SMD

(30) Priorität: 24.03.1992 DE 4209542
(43) Veröffentlichungstag der Anmeldung: 29.09.1993
(73) Patentinhaber: ROEDERSTEIN SPEZIALFABRIKEN FÜR BAUELEMENTE DER ELEKTRONIK UND KONDENSATOREN DER STARKSTROMTECHNIK GmbH, D-84003 Landshut (DE)
(72) Erfinder: Fischer, Kurt, W-8300 Altdorf (DE)
(74) Vertreter: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(56) Entgegenhaltungen:
- EP-A- 0 352 771
- US-A- 3 763 454
- PATENT ABSTRACTS OF JAPAN vol. 16, no. 101 (E-1177)12. März 1992 ( TOSHIBA ) 11. Dezember 1991
- SOVIET INVENTIONS ILLUSTRATED Section EI, Week 8728, 22. Juli 1987 Derwent Publications Ltd. London, GB, Class V03, AN 87-198103/28 & SU-A-1 275 572 (ELEKTROVYPRY AMITEL) / December 1986

## Beschreibung

Die Erfindung betrifft eine Wärme-Überlast-Sicherung zur Fixierung an einem Schaltungssubstrat mit wenigstens einem Federarm, der unter Vorspannung mit einer Kontaktstelle des Substrats mit Hilfe von Reflow-Lötung verlötbar ist, entsprechend dem Oberbegriff des Anspruchs 1.

Eine Sicherung dieser Art ist aus der DE-OS 38 25 897 bekannt. In dieser Offenlegungsschrift wird eine Schmelzsicherung beschrieben, die aus einem U-förmigen Bügel besteht, deren Schenkel die Federarme bilden. Die Federarme werden durch eine Abstützeinrichtung vorgespreizt, die aus einem plastisch deformierbaren Teil der Schmelzsicherung besteht. Nach Verlöten der Schmelzsicherung an dem Substrat werden die die Abstützeinrichtung bildenden Teile verbogen und damit die Abstützwirkung aufgehoben.

Aufgabe der Erfindung ist es eine Wärme-Überlast-Sicherung der eingangs genannten Art so auszubilden, daß sie besonders einfach und günstig herzustellen ist und im Reflow-Lötverfahren auf das Substrat aufgelötet werden kann.

Gelöst wird diese Aufgabe nach der Erfindung durch die im Patentanspruch 1 angegebenen Merkmale.

Nach einer zweckmäßigen Ausführungsform der Erfindung ist die Wärme-Überlast-Sicherung als Rahmenteil, insbesondere als rechteckiges Rahmenteil mit freiliegender Mittelzunge ausgebildet. Im Bereich des Schaftes der Mittelzunge ist das Rahmenteil knieförmig so eingeknickt, daß die Mittelzunge im entspannten Zustand schräg nach oben zeigt und damit den Federarm bildet. Der knieförmig ausgebildete Knick verläuft dabei vorzugsweise senkrecht zur Längsachse des Federarms. Das den Federarm umgebende Rahmenteils liegt dabei im wesentlichen in einer Ebene. Dadurch werden bei Anbringen der Wärme-Überlast-Sicherung an einem Schaltungssubstrat flächige Kontaktstellen ermöglicht, die eine gute Verbindung und Verlötbarkeit mit dem Substrat gewährleisten.

Nach einer weiteren Ausführungsform ist der den Federarm niederhaltende Hilfssteg an der dem freien Ende des Federarms zugewandten Seite des Rahmenteils angeordnet. Bevorzugt ist der Hilfssteg dabei aus dem dem freien Ende des Federarms zugewandten Endteil des Rahmenteils gebildet. Es ist jedoch auch denkbar, den Hilfssteg als separates Teil, das beispielsweise auf das Rahmenteil aufgesteckt wird, auszubilden.

Nach einer weiteren Ausführungsform ist das dem freien Ende des Federarms zugewandte Endteil des Rahmenteils hochgebogen und weist eine zum Federarm zeigende Abstützung auf. Diese hält das freie Ende des Federarms so nieder, daß es in der Rahmenebene angeordnet ist.

Die Abstützung kann dabei durch Biegen des hochgebogenen Endteils nach unten ausgebildet sein, wobei das nach unten gebogene Teil sowohl in Richtung des freien Endes als auch des Schaftes des Federarms zeigen kann.

Nach einer weiteren Ausführungsform umfaßt das hochgebogene Endteil ein zungenförmiges Teil, das zum Federarm hin gebogen ist, und damit die Abstützung zum Niederhalten des Federarms bildet.

Nach einer weiteren vorteilhaften Ausführungsform ist das dem freien Ende des Federarms zugewandte Endteil des Rahmenteils so umgebogen, daß es das freie Ende des Federarms so niederhält, daß dieses in der Rahmenebene angeordnet ist. Dies wird durch ein vollständiges Umbiegen des Endteils, das heißt durch ein Biegen um circa 180° erreicht.

Nach einer weiteren bevorzugten Ausführungsform ist der Hilfssteg über eine Kerblinie zum Abbrechen des Hilfssteges mit der Wärme-Überlast-Sicherung verbunden. Durch einfaches Hin- und Herknicken des Hilfssteges entlang der Kerblinie kann nach Verlöten der Wärme-Überlast-Sicherung der Hilfssteg von der Sicherung getrennt werden, um die beabsichtigte Funktion zu erhalten (Scharfmachen der Sicherung).

Nach einer weiteren zweckmäßigen Ausführungsform sind die Teile der Wärme-Überlast-Sicherung, die nicht verbogen oder geknickt werden sollen, mit Versteifungselementen, insbesondere mit Versteifungsnuten in Form von Prägungen versehen. Dadurch wird die Federwirkung des Federarms verstärkt und eine Coplanarität der Lötflächen erreicht, die die Reflow-Lötfähigkeit des Bauteils gewährleistet.

Das Rahmenteil, der Federarm und der Hilfssteg sind bevorzugt als einheitliches Stanzteil ausgebildet, wodurch eine besonders einfache und kostengünstige Herstellung erreicht wird. Weiterhin ist die Wärme-Überlast-Sicherung vorteilhaft aus Federbronze, insbesondere aus galvanisch vernickel-ter und verzinnter Federbronze hergestellt.

Weitere besonders vorteilhafte Merkmale der Erfindung sind in den Unteransprüchen angegeben.

Der Vorteil der erfindungsgemäß ausgebildeten Wärme-Überlast-Sicherung liegt zum einen in der besonders einfachen und kostengünstigen Herstellung. Zum anderen ist durch die flächige Auflage der Wärme-Überlast-Sicherung an dem Schaltungssubstrat eine besonders wirtschaftliche Montage mittels Reflow-Lötung gewährleistet.

Die Erfindung wird nachfolgend anhand eines Ausführungsbeispiels unter Bezugnahme auf die Zeichnung erläutert; in dieser zeigt:
- Figur 1: eine perspektivische Darstellung einer erfindungsgemäß ausgebildeten Wärme-Überlast-Sicherung in entspanntem Zustand,
- Figur 2: eine erfindungsgemäß ausgebildete Wärme-Überlast-Sicherung nach Figur 1 in gespanntem Zustand,
- Figur 3: eine Wärme-Überlast-Sicherung nach den Figuren 1 und 2 nach Abtrennen des Hilfsstegs in eingelötetem Zustand,
- Figur 4: eine Draufsicht der Wärme-Überlast-Sicherung nach Figur 1 mit zusätzlichen Versteifungselementen,
- Figur 5: eine Seitenansicht der Wärme-Überlast-Sicherung nach Figur 4,
- Figur 6: eine Draufsicht einer weiteren Ausführungsform einer erfindungsgemäß ausgebildeten Wärme-Überlast-Sicherung,
- Figur 7: eine Seitenansicht der Wärme-Überlast-Sicherung nach Figur 6,
- Figur 8: eine Draufsicht einer dritten Ausführungsform einer erfindungsgemäß ausgebildeten Wärme-Überlast-Sicherung und
- Figur 9: eine Seitenansicht der Wärme-Überlast-Sicherung nach Figur 8.

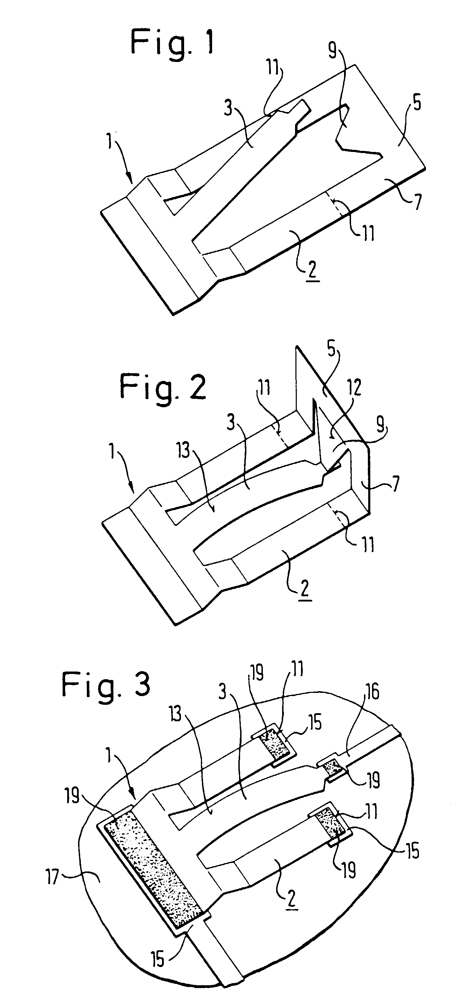

Figur 1 zeigt den Grundaufbau einer Wärme-Überlast-Sicherung 1 in Form eines Stanzteils, bestehend aus einem Rahmenteil 2 mit einer freiliegenden Mittelzunge 3, wobei das Rahmenteil 2 im Bereich des Schaftes der Mittelzunge 3 knieförmig so eingeknickt ist, daß die Mittelzunge 3 schräg nach oben zeigt. Das rechte Endteil 5 des Rahmenteils 2 bildet einen über zwei Kerblinien 11 abtrennbaren Hilfssteg 7 mit einem zungenförmigen Teil 9.

Die nächste Montagestufe der Wärme-Überlast-Sicherung 1 ist in Figur 2 gezeigt. Dabei ist der Hilfssteg 7 nach oben und das zungenförmige Teil 9 so nach vorne gebogen, daß es eine Abstützung 12 bildet, die die Mittelzunge 3 so nach unten hält, daß diese einen vorgespannten Federarm 13 ausbildet. Nach Erreichen dieser Montagestufe befindet sich die Wärme-Überlast-Sicherung 1 in einlötfähigem Zustand.

Figur 3 zeigt die Wärme-Überlast-Sicherung 1 in eingelötetem Zustand. Die Wärme-Überlast-Sicherung 1 ist dabei nach Abbrechen des Hilfsstegs 7 entlang der Kerblinien 11 an Kontaktstellen 15, 16 eines Substrats 17 angelötet. Die Wärme-Überlast-Sicherung 1 ist dabei an den Kontaktstellen 15, 16 über Lötflächen 19 angelötet, die als dunkle Flächen dargestellt sind.

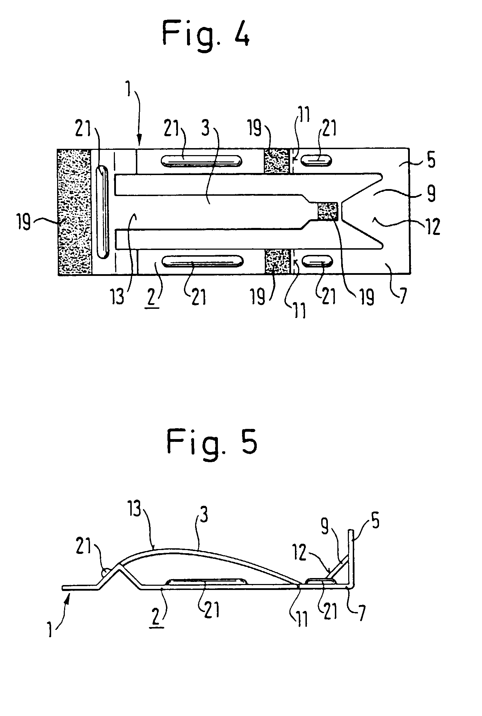

Figur 4 zeigt eine Draufsicht auf die erfindungsgemäß ausgebildete Wärme-Überlast-Sicherung 1 nach den Figuren 1 bis 3, bei der der Hilfssteg 7 in ungeknicktem Zustand dargestellt ist. Bei dieser Ausführungsform sind die Teile des Rahmenteils 2, die nicht verbogen oder geknickt werden dürfen, mit Versteifungselementen 21 versehen, die insbesondere als Versteifungsnuten in Form von Prägungen ausgebildet sind. Die Lötflächen 19, über die die Wärme-Überlast-Sicherung 1 am Substrat 17 fixiert wird, sind wie in Figur 3 als dunkle Flächen gekennzeichnet.

Figur 5 zeigt den einlötfähigen Zustand der Wärme-Überlast-Sicherung 1 nach Figur 4. Der Hilfssteg 7 ist dabei nach oben und das zungenförmige Teil 9 so schräg nach vorne gebogen, daß es die Abstützung 12 bildet, die den Federarm 13 nach unten in der vorgespannten Stellung hält.

Durch das Niederhalten des Federarms 13 durch den HilfsSteg 7 kann die Wärme-Überlast-Sicherung 1 über die Lötflächen 19 an den Kontaktstellen 15, 16 des Substrats 17 einfach per Reflow-Lötung angelötet werden. Nach Abtrennen des Hilfsstegs 7 entlang der Kerblinien 11 von der Wärme-Überlast-Sicherung 1 ist die Fixierung der Wärme-Überlast-Sicherung 1 am Substrat 17 beendet und die Funktionsfähigkeit gewährleistet.

Tritt an der Kontaktstelle 16 durch eine thermische Überlastung eine so hohe Temperatur auf, daß das an der Kontaktstelle 16 befindliche Lot zum Schmelzen gebracht wird, so schnellt der unter Vorspannung stehende Federarm 13 nach oben in seine entspannte Position und unterbricht dabei den über die Wärme-Überlast-Sicherung geschlossenen Stromkreis.

Wird beispielsweise an der Rückseite der Kontaktstelle 16 oder in deren Umgebung auf der Sicherungsseite ein Schichtwiderstand angebracht, so kann durch die Wärme-Überlast-Sicherung die thermische Belastung dieses Schichtwiderstandes überwacht werden.

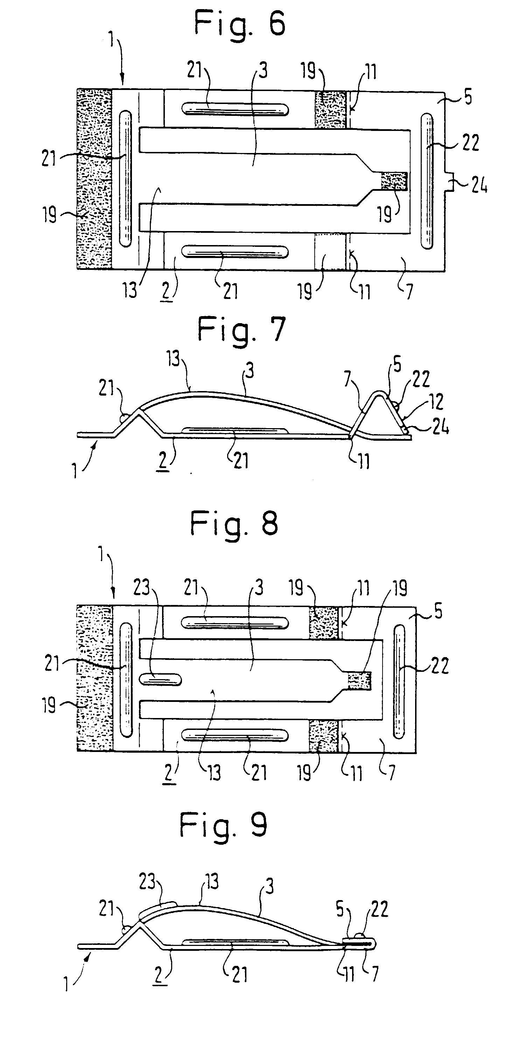

Figur 6 zeigt eine Draufsicht auf eine weitere vorteilhafte Ausführungsform einer erfindungsgemäß ausgebildeten Wärme-Überlast-Sicherung 1. Dabei ist der Hilfssteg 7 als einfaches U-förmiges Endteil 5 ausgebildet, das mittensymmetrisch einen Ansatz 24 aufweist. Der Hilfssteg 7 ist dabei mit einem Versteifungselement 22 in Form einer Ausprägung versehen.

Figur 7 zeigt den einlötfähigen Zustand der Wärme-Überlast-Sicherung nach Figur 6. Dabei ist der Hilfssteg nach oben gebogen und das freie Ende des hochgebogenen Hilfssteges 7 nach unten so abgeknickt, daß es die Abstützung 12 bildet, die über den Ansatz 24 den Federarm 13 in seiner vorgespannten Stellung niederhält.

Figur 8 zeigt eine weitere Ausführungsform einer erfindungsgemäß ausgebildeten Wärme-Überlast-Sicherung 1 mit einem U-förmig ausgebildeten Hilfssteg 7. Der Federarm 13 ist dabei an seinem Schaft mit einem Versteifungselement 23 in Form einer Ausprägung versehen, um ein Abknicken des Federarms 13 am Schaft zu verhindern.

Figur 9 zeigt den einlötfähigen Zustand der Wärme-Überlast-Sicherung 1 nach Figur 8, bei der der Hilfssteg 7 durch vollständiges Umknicken, das heißt durch Umknicken um circa 180°, den Federarm 13 in seine vorgespannte Stellung niederhält. Durch das Versteifungselement 23 am Schaft des Federarms 13 wird ein Abknicken an dieser besonders gefährdeten Stelle verhindert.

## Patentansprüche

1. Wärme-Überlast-Sicherung (1) zur Verlötung an einem Schaltungssubstrat (17) mit wenigstens einem Federarm (13), der unter fixierter Vorspannung mit einer Kontaktstelle (16) des Substrats (17) verlötbar ist,
dadurch **gekennzeichnet,**
daß der an einem zumindest im wesentlichen ebenen Rahmenteil (2) befestigte Federarm (13) im entspannten Zustand eine gegenüber dem Substrat (17), insbesondere der Kontaktstelle (16), in senkrechter Richtung beabstandete Stellung einnimmt, daß das freie Ende des Federarms (13) durch zumindest einen Hilfssteg (7) auf das Substrat (17), insbesondere auf die Kontaktstelle (16), niedergehalten ist und daß der Hilfssteg (7) entlang einer vorbestimmten Linie von dem Rahmenteil (2) abtrennbar ist.

2. Wärme-Überlast-Sicherung (1) nach Anspruch 1,
dadurch **gekennzeichnet,**
daß das Rahmenteil (2) als rechteckiges Rahmenteil (2) mit freiliegender Mittelzunge (3) ausgebildet ist, wobei im Bereich des Schaftes der Mittelzunge (3) das Rahmenteil (2) knieförmig so eingeknickt ist, daß die Mittelzunge (3) im entspannten Zustand schräg nach oben zeigt und damit den Federarm (13) bildet.

3. Wärme-Überlast-Sicherung (1) nach den Ansprüchen 1 oder 2,
dadurch **gekennzeichnet,**
daß der knieförmig ausgebildete Knick senkrecht zur Längsachse des Federarms (13) verläuft.

4. Wärme-Überlast-Sicherung (1) nach einem oder mehreren der vorhergehenden Ansprüche,
**dadurch gekennzeichnet,**
daß der den Federarm (13) niederhaltende Hilfssteg (7) an der dem freien Ende des Federarms (13) zugewandten Seite des Rahmenteils (2) angeordnet ist.

5. Wärme-Überlast-Sicherung (1) nach einem oder mehreren der vorhergehenden Ansprüche,
dadurch **gekennzeichnet,**
daß der den Federarm (13) niederhaltende Hilfssteg (7) aus dem dem freien Ende des Federarms (13) zugewandten Endteil (5) des Rahmenteils (2) gebildet ist.

6. Wärme-Überlast-Sicherung (1) nach Anspruch 5,
dadurch **gekennzeichnet,**
daß das dem freien Ende des Federarms (13) zugewandte Endteil (5) des Rahmenteils (2) hochgebogen ist und eine zum Federarm (13) zeigende Abstützung (12) aufweist, die das freie Ende des Federarms (13) so niederhält, daß es in der Rahmenebene angeordnet ist.

7. Wärme-Überlast-Sicherung (1) nach Anspruch 6,
dadurch **gekennzeichnet,**
daß das freie Ende des hochgebogenen Endteils (5) nach unten gebogen ist und damit die Abstützung (12) zum Niederhalten des Federarms (13) bildet.

8. Wärme-Überlast-Sicherung (1) nach Anspruch 6,
dadurch **gekennzeichnet,**
daß das hochgebogene Endteil (5) ein zungenförmiges Teil (9) umfaßt, das zum Federarm (13) hin gebogen ist, und damit die Abstützung (12) zum Niederhalten des Federarms (13) bildet.

9. Wärme-Überlast-Sicherung (1) nach Anspruch 5,
dadurch **gekennzeichnet,**
daß das dem freien Ende des Federarms (13) zugewandte Endteil (5) des Rahmenteils (2) so, insbesondere um circa 180° umgebogen ist, daß es das freie Ende des Federarms (13) so niederhält, daß dieses in der Rahmenebene angeordnet ist.

10. Wärme-Überlast-Sicherung (1) nach einem oder mehreren der vorhergehenden Ansprüche,
dadurch **gekennzeichnet,**
daß der Hilfssteg (7) über eine Kerblinie (11) zum Abbrechen des Hilfssteges (7) mit der Wärme-Überlast-Sicherung (1) verbunden ist.

11. Wärme-Überlast-Sicherung (1) nach einem oder mehreren der vorhergehenden Ansprüche,
dadurch **gekennzeichnet,**
daß das Rahmenteil (2), der Federarm (13) und der Hilfssteg (7) als einheitliches Stanzteil ausgebildet sind.

12. Wärme-Überlast-Sicherung (1) nach einem oder mehreren der vorhergehenden Ansprüche,
dadurch **gekennzeichnet,**
daß die nicht zu verbiegenden oder nicht zu knickenden Teile der Wärme-Überlast-Sicherung (1) mit Versteifungselementen (21, 22, 23), insbesondere mit Versteifungsnuten in Form von Prägungen versehen sind.

13. Wärme-Überlast-Sicherung (1) nach einem oder mehreren der vorhergehenden Ansprüche,
dadurch **gekennzeichnet,**
daß das Rahmenteil (2), der Federarm (13) und der Hilfssteg (7) aus Federbronze, insbesondere aus galvanisch vernickelter und verzinnter Federbronze hergestellt sind.

## Claims

1. Thermal overload fuse (1) for soldering to a circuit substrate (17) having at least one spring arm (13) which is solderable, under fixed pre-stress, to a contact location (16) of the substrate (17),
characterised in that
the spring arm (13), which is fixed to an at least substantially planar frame part (2), adopts, in its relaxed state, a position which is spaced in a perpendicular direction relative to the substrate (17), in particular relative to the contact location (16); and in that
the free end of the spring arm (13) is held down by at least one auxiliary web (7) onto the substrate (17), in particular onto the contact location (16); and in that
the auxiliary web (7) is detachable from the frame part (2) along a predetermined line.

2. Thermal overload fuse (1) as set forth in claim 1,
characterised in that
the frame part (2) is constructed as a rectangular frame part (2) with a free lying central tongue (3), wherein in the region of the shank of the central tongue (3), the frame part (2) is kinked in a knee-like fashion so that the central tongue (3) points obliquely upwards in its relaxed state, thereby forming the spring arm (13).

3. Thermal overload fuse (1) as set forth in claim 1,
characterised in that
the knee-like kink extends perpendicular relative to the longitudinal axis of the spring arm (13).

4. Thermal overload fuse (1) as set forth in claim 1,
characterised in that
the auxiliary web (7) holding down the spring arm (13) is arranged at the side of the frame part (2) facing towards the free end of the spring arm (13).

5. Thermal overload fuse (1) as set forth in claim 1,
characterised in that
the auxiliary web (7) holding down the spring arm (13) is formed from the end part (5) of the frame part (2) facing towards the free end of the spring arm (13).

6. Thermal overload fuse (1) as set forth in claim 5,
characterised in that
the end part (5) of the frame part (2) which faces towards the free end of the spring arm (13) is bent upwards and has a support (12) pointing towards the spring arm (13) which holds down the free end of the spring arm (13) so that the free end is arranged in the plane of said frame.

7. Thermal overload fuse (1) as set forth in claim 6,
characterised in that
the free end of the upwardly bent end part (5) is bent downwards thereby forming the support (12) for the holding down of the spring arm (13).

8. Thermal overload fuse (1) as set forth in claim 6,
characterised in that
the upwardly bent end piece includes a tongue-shaped part (9) which is bent towards the spring arm (13) thereby forming the support (12) for the holding down of the spring arm (13).

9. Thermal overload fuse (1) as set forth in claim 5,
characterised in that
the end part (5) of the frame part (2) facing towards the free end of the spring arm (13) is bent round, in particularly by approximately 180°, so that it holds down the free end of the spring arm (13) so that the this end is arranged in the plane of the frame.

10. Thermal overload fuse (1) as set forth in one claim 1,
characterised in that
the auxiliary web (7) is connected to the thermal overload fuse (1) via a notch line (11) for the breaking off of the auxiliary web (7).

11. Thermal overload fuse (1) as set forth in claim 1,
characterised in that
the frame part (2), the spring arm (13) and the auxiliary web (7) are constructed as a unitary stamped part.

12. Thermal overload fuse (1) as set forth in claim 1,
characterised in that
those parts of the thermal overload fuse (1) which are not to be bent or kinked are provided with stiffening elements (21, 22, 23) in particular with stiffening grooves of an embossed form.

13. Thermal overload fuse (1) as set forth in claim 1,
characterised in that
the frame part (2), the spring arm (13) and the auxiliary web (7) are manufactured from spring bronze, in particular from galvanically nickelled and tinned spring bronze.

## Revendications

1. Sécurité thermique de surcharge (1) conçue pour être montée par brasage sur un substrat de circuit (17), comportant au moins un bras de ressort (13), pouvant être brasé, sous pré-contrainte fixe, en un point de contact (16) du substrat (17), caractérisé en ce que le bras de ressort (13) fixé sur une partie cadre (2) au moins sensiblement plane, prend, à l'état relaxé, une position espacée en direction perpendiculaire par rapport au substrat (17), en particulier au point de contact (16), en ce que l'extrémité libre du bras de ressort (13) est maintenue abaissée sur le substrat (17) en particulier au point de contact (16), au moyen d'au moins une traverse auxiliaire (7), et en ce que la traverse auxiliaire (7) est susceptible d'être séparée de la partie cadre (2), suivant une ligne prédéterminée.

2. Sécurité thermique de surcharge (1) selon la revendication 1, caractérisée en ce que la partie cadre (2) est réalisée sous forme de partie cadre (2) rectangulaire comportant une languette médiane (3) libre, la partie cadre (2) étant infléchie en forme de genou, dans la zone de la tige de la languette médiane (3), de manière que la languette médiane (3) soit orientée vers le haut obliquement à l'état relaxé et constitue ainsi le bras de ressort (13).

3. Sécurité thermique de surcharge (1) selon la revendication 1 ou 2, caractérisée en ce que l'inflexion réalisée en forme de genou court perpendiculairement par rapport à l'axe longitudinal du bras de ressort (13).

4. Sécurité thermique de surcharge (1) selon l'une ou plusieurs des revendications précédentes, caractérisée en ce que la traverse auxiliaire (7) maintenant abaissé le bras de ressort (13) est disposée sur la face, tournée vers l'extrémité libre du bras de ressort (13), de la partie cadre (2).

5. Sécurité thermique de surcharge (1) selon l'une ou plusieurs des revendications précédentes, caractérisée en ce que la traverse auxiliaire (7) maintenant abaissé le bras de ressort (13) est constituée de la partie d'extrémité (5), tournée vers l'extrémité libre du bras de ressort (13), de la partie cadre (2).

6. Sécurité thermique de surcharge (1) selon la revendication 5, caractérisée en ce que la partie d'extrémité (5), tournée vers l'extrémité libre du bras de ressort (13), de la partie cadre (2) est repliée vers le haut et présente un appui (12) tourné vers le bras de ressort (13), qui maintient abaissée l'extrémité libre du bras de ressort (13) de manière à ce qu'elle soit disposée dans le plan du cadre.

7. Sécurité thermique de surcharge (1) selon la revendication 6, caractérisée en ce quel'extrémité libre de la partie d'extrémité (5) relevée vers le haut est repliée vers le bas et constitue ainsi l'appui (12) destiné au maintien abaissé du bras de ressort (13).

8. Sécurité thermique de surcharge (1) selon la revendication 6, caractérisée en ce que la partie d'extrémité (5) repliée vers le haut comprend une partie (9) en forme de languette qui est repliée en direction du bras de ressort (13) et constitue ainsi l'appui (12) destiné à maintenir abaissé le bras de ressort (13).

9. Sécurité thermique de surcharge (1) selon la revendication 5, caractérisée en ce que la partie d'extrémité (5), tournée vers l'extrémité libre du bras de ressort (13), de la partie cadre (2) est repliée, en particulier d'environ 180°, de manière à maintenir abaissée l'extrémité libre du bras de ressort (13) pour que celui-ci soit disposé dans le plan du cadre.

10. Sécurité thermique de surcharge (1) selon l'une ou plusieurs revendications précédentes, caractérisée en ce que la traverse auxiliaire (7) est reliée à la sécurité thermique de surcharge (1) au moyen d'une ligne d'entaille (11) destinée à produire la rupture de la traverse auxiliaire (7).

11. Sécurité thermique de surcharge (1) selon l'une ou plusieurs des revendications précédentes, caractérisée en ce que la partie cadre (2), le bras de ressort (13) et la traverse auxiliaire (7) sont réalisés sous forme de pièce estampée unitaire.

12. Sécurité thermique de surcharge (1) selon l'une ou plusieurs revendications précédentes, caractérisée en ce que les parties qui ne sont pas à plier ni à infléchir de la sécurité thermique de surcharge (1) sont pourvues d'éléments de rigidification (21, 22, 23), en particulier présentant des nervures de rigidification réalisées sous la forme d'empreintes.

13. Sécurité thermique de surcharge (1) selon l'une ou plusieurs revendications précédentes, caractérisée en ce que la partie cadre (2), le bras de ressort (13) et la traverse auxiliaire (7) sont fabriqués en bronze à ressort, en particulier, en bronze à ressort ayant été nickelé et galvanisé-zingué, par voie galvanique.
